(19) Europäisches Patentamt
European Patent Office
Office européen des brevets

(11) Publication number: 0 405 986 A2

(12) EUROPEAN PATENT APPLICATION

(21) Application number: 90307103.3

(51) Int. Cl.5: G03F 7/32, G03F 7/30

(22) Date of filing: 28.06.90

(30) Priority: 29.06.89 JP 168639/89

(43) Date of publication of application:
02.01.91 Bulletin 91/01

(84) Designated Contracting States:
DE GB

(71) Applicant: KONICA CORPORATION
No. 26-2, Nishishinjuku 1-chome Shinjuku-ku
Tokyo(JP)

(72) Inventor: Shimura, Kazuhiro, C/o Konica Corporation
1, Sakuramachi
Hino-shi, Tokyo(JP)
Inventor: Uehara, Masafumi, C/o Konica Corporation
1, Sakuramachi
Hino-shi, Tokyo(JP)
Inventor: Nogami, Akira, C/o Konica Corporation
1, Sakuramachi
Hino-shi, Tokyo(JP)
Inventor: Watanabe, Sinya, C/o Konica Corporation
1, Sakuramachi
Hino-shi, Tokyo(JP)

(74) Representative: Ellis-Jones, Patrick George Armine et al
J.A. KEMP & CO. 14 South Square Gray's InnInn
London WC1R 5LX(GB)

# (54) method of processing presensitized lithographic printing plate.

(57) Disclosed is a method of processing a presensitized lithographic printing plate by the use of an automatic processor, comprising processing a negative working presensitized lithographic printing plate containing a diazo compound and a positive working presensitized lithographic printing plate containing an o-quinonediazide compound, with a developer solution capable of processing the negative working presensitized lithographic printing plate and the positive working presensitized lithographic printing plate in common, repeatedly used under supply of a developer replenishing solution, wherein;
the developer solution and the developer replenishing solution each contain an alkali silicate, a surface active agent, an organic solvent and a reducing agent;
the developer replenishing solution is a single liquid; the developer replenishing solution contains the surface active agent in an amount ranging from 0.05 to 15 % by weight; and
the developer replenishing solution is different from the developer solution in the concentration of at least one of the alkali silicate, the surface active agent, the organic solvent and the reducing agent.

EP 0 405 986 A2

# METHOD OF PROCESSING PRESENSITIZED LITHOGRAPHIC PRINTING PLATE

## BACKGROUND OF THE INVENTION

This invention relates to a method of processing a presensitized lithographic printing plate. More particularly, it relates to a method of processing a negative working presensitized lithographic printing plate (hereinafter often "negative working PS plate") and a positive working presensitized lithographic printing plate (hereinafter often "positive working PS plate") with a developer solution capable of processing the negative working PS plate and the positive working PS plate in common under supply of a replenishing solution, using an automatic processor.

As a method of processing a negative working PS plate and a positive working PS plate with a developer solution common to the negative working PS plate and the positive working PS plate, which can be carried out in a stable state for a long period of time using one automatic processor under supply of a replenishing solution, Japanese Unexamined Patent Publication No. 73271/1987 discloses a method in which an alkaline developer solution containing a silicate as an alkali agent and also containing an anionic surface active agent, a sulfite, etc. is supplied with a developer replenishing solution containing an alkali agent in a greater amount. It also discloses a method in which a replenishing solution is made to have a two-part liquid system, and is supplied in mixing ratios different between a negative working PS plate and a positive working PS plate.

In the former method, however, a difference tends to be caused between the components actually consumed and the components supplied, bringing about the problem of a gradual lowering of development quality. In the latter method, two types of developer replenishing solutions are required, and an apparatus designed therefor becomes necessary, bringing about the problems that the method is uneconomical and requires complicated management.

## SUMMARY OF THE INVENTION

In a method of processing a negative working PS plate and a positive working PS plate with a developer solution capable of processing both the printing plates in common under supply of a replenishing solution, an object of this invention is to provide a method that can stably maintain development quality and also can simplify the manner for replenishing a developer solution and the apparatus used therefor.

The above object of this invention can be achieved by a method of processing a presensitized lithographic printing plate by the use of an automatic processor, comprising processing a negative working presensitized lithographic printing plate containing a diazo compound and a positive working presensitized lithographic printing plate containing an o-quinonediazide compound, with a developer solution capable of processing the negative working presensitized lithographic printing plate and the positive working presensitized lithographic printing plate in common, repeatedly used under supply of a developer replenishing solution, wherein;

said developer solution and said developer replenishing solution each contain an alkali silicate, a surface active agent, an organic solvent and a reducing agent;

said developer replenishing solution is a single liquid;

said developer replenishing solution contains said surface active agent in an amount ranging from 0.05 to 15 % by weight; and

said developer replenishing solution is different from said developer solution in the concentration of at least one of the alkali silicate, the surface active agent, the organic solvent and the reducing agent.

In a preferred embodiment, the above processing method is characterized in that the developer replenishing solution is supplied in an amount that is varied depending on the amount of processing of the negative working PS plate and the positive working PS plate.

## BRIEF DESCRIPTION OF THE DRAWINGS

Figs. 1 and 3 are sectional views to illustrate examples of apparatus used in Examples.

Fig. 2 is a graph to show the relationship between the processing ratio for negative PS plates and positive PS plates and amount of replenishment in Examples.

## DESCRIPTION OF THE PREFERRED EMBODIMENTS

The developing solution capable of processing the negative working PS plate and the positive working PS plate in common (hereinafter often "negative PS/positive PS common developer solution") and the developer replenishing solution therefor, used in the method of this invention, each contain an alkali silicate as an alkali agent. The alkali silicate includes, for example, potassium silicate, sodium silicate, sodium metasilicate, potassium metasilicate, and ammonium silicate, and the like. The alkali silicate may preferably be contained in the developer solution in an amount ranging from 0.3 to 10 % by weight. The alkali silicate may be in an amount ranging from 0.1 to 7.0 % by weight in terms of $SiO_2$ concentration. The alkali silicate may also preferably be contained in the developer replenishing solution in an amount ranging from 0.5 to 10 % by weight.

In the developer solution and developer replenishing solution used in this invention, an alkali agent other than the alkali silicate can be used in combination. For example, an inorganic alkali agent such as potassium hydroxide, sodium hydroxide, lithium hydroxide, sodium tertiary phosphate, sodium secondary phosphate, potassium tertiary phosphate, potassium secondary phosphate, ammonium tertiary phosphate, ammonium secondary phosphate, sodium metasilicate, sodium bicarbonate, sodium carbonate, potassium carbonate or ammonium carbonate, and an organic alkali agent such as mono-, di- or triethanolamine or a tetraalkyl hydroxide can be used in combination.

The surface active agent contained in the developer solution and developer replenishing solution in this invention may preferably be at least one selected from an anionic surface active agent, a nonionic surface active agent and a cationic surface active agent. It may particularly preferably be a nonionic surface active agent.

The anionic surface active agent includes higher alcohol ($C_8$ to $C_{22}$) sulfuric acid ester salts as exemplified by a sodium salt of lauryl alcohol sulfate, a sodium salt of octyl alcohol sulfate, an ammonium salt of lauryl alcohol sulfate, Teepol-81 (trade name; available from Shell Kagaku K.K.) and a disodium alkylsulfate, aliphatic alcohol phosphoric acid ester salts as exemplified by a sodium salt of cetyl alcohol phosphoric acid ester, alkylaryl sulfonic acid salts as exemplified by a sodium salt of dodecylbenzenesulfonic acid, a sodium salt of isopropylnaphthalenesulfonic acid, a sodium salt of dinaphthalenedisulfonic acid and a sodium salt of metanitrobenzenesulfonic acid, sulfonates of alkylamides as exemplified by $C_{17}H_{33}CON(CH_33)CH_2SO_3Na$, and sulfonates of dibasic fatty acid esters as exemplified by dioctyl sodium sulfosuccinate and dihexyl sodium sulfosuccinate. In particular, the sulfonates are preferably used.

The nonionic surface active agent includes polyethylene glycol types and polyhydric alcohol types, both of which can be used. From the viewpoint of development performance, nonionic surface active agents of a polyethylene glycol type are preferred, among which more preferred is a nonionic surface active agent having three or more ethylene oxy groups ($-CH_2CH_2O-$) and also having an HLB value (HLV is the abbreviation for hydrophile-lipophile balance) of not less than 5 (more preferably from 8 to 20).

Examples of the nonionic surface active agent are shown below.

Polyethylene glycol, polyoxyethylene lauryl ether, polyoxyethylene nonyl ether, polyoxyethylene cetyl ether, polyoxyethylene stearyl ether, polyoxyethylene oleyl ether, polyoxyethylene behenyl ether, polyoxyethylene polyoxypropylene cetyl ether, polyoxyethylene polyoxypropylene behenyl ether, polyoxyethylene nonyl phenyl ether, polyoxyethylene octyl phenyl ether, polyoxyethylene stearylamine, polyoxyethylene oleylamine, polyoxyethylene stearic acid amide, polyoxyethylene oleic acid amide, polyoxyethylene castor oil, polyoxyethylene abietyl ether, polyoxyethylene lanolin ether, polyoxyethylene monolaurate, polyoxyethylene monostearate, polyoxyethylene glyceryl monooleate, polyoxyethylene glyceryl monostearate, polyoxyethylene propylene glycol monostearate, an oxyethylene oxypropylene block polymer, a distyrated-phenol polyethylene oxide adduct, a tribenzylphenol polyethylene oxide adduct, an octylphenol polyoxyethylene polyoxypropylene adduct, glycerol monostearate, sorbitan monolaurate, polyoxyethylene sorbitan monolaurate, etc.

The nonionic surface active agent may preferably have a weight average molecular weight ranging from 300 to 10,000, and particularly preferably from 500 to 5,000. The nonionic surface active agent may be used alone or in combination of two or more kinds.

Of the nonionic surface active agents, those having both an ethylene oxy group and a propylene oxy group are particularly preferred, among which those having an HLB value of not less than 8 are more preferred.

Preferred examples of the nonionic surface active agent include the compounds represented by the following Formulas (1) to (8).

(1) $R-O-(CH_2CH_2O)_nH$

(2) 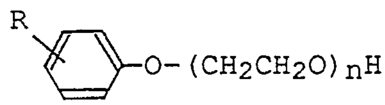

(3) 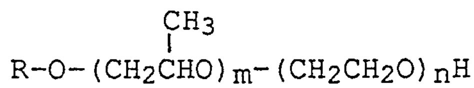

(4) 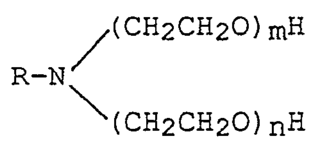

(5) 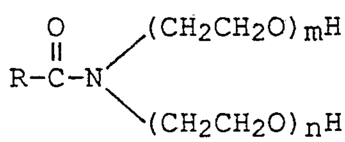

(6) $HO(C_2H_4O)_a-(C_3H_6O)_b-(C_2H_4O)_cH$

(7) 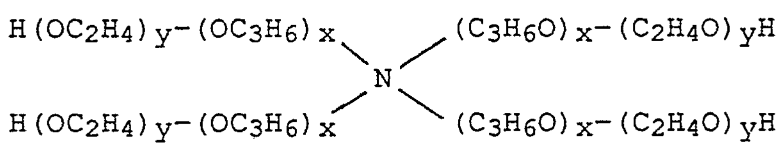

(8) $HO-(CH_2CH_2O)_nH$

In Formulas (1) to (8), R represents a hydrogen atom or a monovalent organic group. Such an organic group includes, for example, a straight-chain or branched alkyl group having 1 to 30 carbon atoms which may have a substituent as exemplified by an aryl group such as phenyl, an alkylcarbonyl group in which the alkyl moiety is as the above alkyl group, and a phenyl group which may have a substituent as exemplified by a hydroxyl group and an alkyl group like the above. The letter symbols a, b, c, m, n, x and y each represent an integer of 1 to 40.

The cationic surface active agent is roughly grouped into amine types and quaternary ammonium salt types, both of which can be used.

Examples of the amine types are a polyoxyethylene alkylamine, a N-alkylpropyleneamine, a N-alkylpolyethylene polyamine, a N-alkylpolyethylene polyamine dimethyl sulfate, an alkylbiguanide, a long-chain amine oxide, an alkylimidazoline, a 1-hydroxyethyl-2-alkylimidazoline, a 1-acetylaminoethyl-2-alkylimidazoline, a 2-alkyl-4-methyl-4-hydroxymethyloxazoline, and the like.

Examples of the quaternary ammonium salt types are a long-chain primary amine salt, an alkyltrimethylammonium salt, a dialkyldimethylethylammonium salt, an alkyldimethylammonium salt, an alkyldimethylbenzylammonium salt, an alkylpyridinium salt, an alkylquinolinium salt, an alkyl isoquinolinium salt, an alkylpyridinium sulfate, a stearamidomethylpyridinium salt, an acylaminoethyl diethylamine salt, an acylaminoethyl methyldiethylammonium salt, an alkylamidopropyl dimethylbenzylammonium salt, a fatty acid polyethylene polyamide, an acylaminoethylpyridinium salt, an acylcolaminoformylmethylpyridinium salt, a stearoxymethylpyridinium salt, a fatty acid triethanolamine, a fatty acid triethanolamine formate, a trioxyethylene fatty acid triethanolamine, a fatty acid dibutylaminoethanol, a cetyloxymethylpyridinium salt, and a p-isooctylphenoxyethoxyethyl dimethylbenzylammonium salt, and the like. In the above, "alkyl" represents a straight-chain or partially substituted alkyl having 6 to 20 carbon atoms, where, specifically stated, straight-chain alkyls such as hexyl, octyl, cetyl and stearyl are preferably used.

In particular, cationic surface active agents of a water-soluble quaternary ammonium type are effective, among which preferred are an alkyltrimethylammonium salt, an alkyldimethylbenzylammonium salt, an ethylene oxide addition ammonium salt and so forth. Polymers having a cationic component as a repeating unit can also be grouped into a cationic surface active agent in a broad sense, and are included in the cationic surface active agent of this invention. In particular, a polymer containing a quaternary ammonium salt, obtained by copolymerization with a lipophilic monomer, can preferably be used.

Such a polymer may have a weight average molecular weight ranging from 300 to 50,000, and particularly preferably from 500 to 5,000. These cationic surface active agents may be used alone or in combination of two or more kinds.

The surface active agent may preferably be contained in the developer solution in an amount ranging from 0.01 to 10 % by weight. In the developer replenishing solution, the surface active agent may be contained in an amount ranging from 0.05 to 15 % by weight, and preferably from 0.1 to 10 % by weight.

The organic solvent contained in the developer solution and developer replenishing solution according to this invention includes, for example, carboxylic acid esters such as ethyl acetate, propyl acetate, butyl acetate, benzyl acetate, ethylene glycol monobutylacetate, butyl lactate, and butyl levulinate; ketones such as ethyl butyl ketone, methyl isobutyl ketone, and cyclohexanone; alcohols such as ethylene glycol monobutyl ether, ethylene glycol benzyl ether, ethylene glycol monophenyl ether, propylene glycol, propylene glycol monomethyl ether, benzyl alcohol, methylphenylcarbinol, n-amyl alcohol, methylamino-alcohol, monoethanolamine, diethanolamine, triethanolamine, and β-anilinoethanol; alkyl-substituted aromatic hydrocarbons such as xylene; and halogenated hydrocarbons such as methylene dichloride, ethylene dichloride, and monochlorobenzene. Of these organic solvents, propylene glycol, triethanolamine and β-anilinoalcohol are preferred. One or more of these organic solvents may be used. The organic solvent may preferably be contained in the developer solution in an amount ranging from 0.05 to 10 % by weight. In the developer replenishing solution, the organic solvent may preferably be used in an amount ranging from 0.05 to 10 % by weight.

As the reducing agent contained in the developer solution and developer replenishing solution according to this invention, it is possible to use a water-soluble or alkali-soluble organic or inorganic reducing agent.

The organic reducing agent includes, for example, phenolic compounds such as hydroquinone, methol and methoxyquinone, and amine compounds such as phenylenediamine and phenylhydrazine. The inorganic reducing agent includes, for example, sulfites such as sodium sulfite, potassium sulfite, ammonium sulfite, sodium hydrogensulfite, and potassium hydrogensulfite; phosphites such as sodium phosphite, potassium phosphite, sodium hydrogenphosphite, potassium hydrogenphosphite, sodium dihydrogenphosphite, and dipotassium hydrogenphosphite; hydrazine, sodium thiosulfate, and sodium dithiosulfite. Sulfites are reducing agents that can bring about a particularly superior effect in this invention.

The reducing agent may preferably be contained in the developer solution in an amount ranging from 0.1 to 20 % by weight. In the developer replenishing solution, the reducing agent may preferably be contained in an amount ranging from 0.5 to 30 % by weight.

In this invention, in respect of (A) the alkali silicate, (B) the surface active agent, (C) the organic solvent and (D) the reducing agent which are contained in the developer solution and developer replenishing solution, the concentration of at least one of the components (A) to (D) is made different between the developer solution and the developer replenishing solution.

The following are preferred embodiments in which the concentration(s) of the components (A) to (D) is/are made different between the developer solution and the developer replenishing solution.

(1) The concentration of the surface active agent is made higher in the developer replenishing solution than in the developer solution.

(2) The concentration of the reducing agent is made higher in the developer replenishing solution than in the developer solution.

In this invention, the developer replenishing solution can be formed as a single liquid by making the

concentration(s) of the components (A) to (D) different between the developer solution and the developer replenishing solution. Thus, the replenishment of the developer solution can be operated with ease and the processing apparatus can be made simple. In this invention, the developer replenishing solution is comprised of a single liquid, where also included in this invention is a form in which a concentrated solution is used as the developer replenishing solution and is diluted with diluting water.

In this invention, the concentration of the developer replenishing solution is preferably 1.1 to 1.8 times that of the developer solution.

In the developer solution and developer replenishing solution used in this invention, the following additives can be added to the above components so that development performance can be enhanced. They include, for example, neutral salts such as NaCl, KCl and KBr, as disclosed in Japanese Unexamined Patent Publication No. 75152/1983; chelating agents such as EDTA and NTA, as disclosed in Japanese Unexamined Patent Publication No. 190952/1984; complexes such as $[Co(NH_3)]_6Cl_3$, as disclosed in Japanese Unexamined Patent Publication No. 121336/1984; polymeric ampholytes such as a copolymer of vinylbenzyl trimethylammonium chloride with sodium acrylate, as disclosed in Japanese Unexamined Patent Publication No. 142528/1981; inorganic lithium compounds such as lithium chloride, as disclosed in Japanese Unexamined Patent Publication No. 59444/1983; organic lithium compounds such as lithium benzoate, as disclosed in Japanese Patent Publication No. 34442/1975; organic metal surface active agents containing Si, Ti or the like, as disclosed in Japanese Unexamined Patent Publication No. 75255/1984; organic boron compounds as disclosed in Japanese Unexamined Patent Publication No. 84241/1984; and organic carboxylic acids as disclosed in Japanese Unexamined Patent Publication No. 188142/1988.

In this invention, the developer replenishing solution may preferably have a higher pH value than that of the developer solution. The pH of the developer solution may preferably be from 12.5 to 13.5, and the pH of the developer replenishing solution, from 12.8 to 13.8.

In a preferred embodiment of this invention, the amount of replenishment is varied depending on the amount of processing of the negative working PS plate and the positive working PS plate. Herein, the amount of processing refers to the proportion of processed areas. The relationship between the amount of processing and the amount of replenishment can be experimentally predetermined with ease.

In this invention, the amount of processing of the negative working PS plate and the positive working PS plate may be preset through the day. More specifically, the amount of processing may be predetermined through the day, and the developer replenishing solution may be supplied through the day in an average amount of replenishment corresponding to the predetermined amount of processing so that the amounts of replenishment may not be changed every time for the negative working PS plate and the positive working PS plate.

In this invention, the amount of replenishment for the developer replenishing solution may also be controlled depending on the processing areas, number, and longitudinal length (in the transfer direction) of the PS plates to be processed. The developer solution may also be replenished against the fatigue caused by any factors other than the processing of the PS plates, as in the replenishment with time.

The negative working PS plate processed according to the method of this invention has a photosensitive layer that employs a diazo compound as a photosensitive component. The positive working PS plate has a photosensitive layer that employs an o-quinonediazide compound as a photosensitive component. They are exemplified by the PS plates as disclosed in Japanese Unexamined Patent Publication No. 175757/1987, page 5, lower left column, line 18 to page 7, upper right column, line 11.

This invention will be described below by giving Examples. In the following, "part(s)" is by weight.

Example 1

The following developer solution (24 liters) was put in a developer solution tank 4 of an automatic processor as shown in Fig. 1, and the following developer replenishing solution (A), in a developer replenishing solution tank 8.

| Developer solution: | |
|---|---|
| β-Anilinoethanol | 0.3 part |
| Propylene glycol | 0.3 part |
| 2-Hydroxy-3-naphthoic acid | 0.6 part |
| p-tert-Butyl benzoic acid | 1.2 parts |
| Emulgen 147 (a nonionic surface active agent, available from Kao Corporation) | 0.05 part |
| Aqueous potassium silicate solution ($SiO_2$ content: 26 % by weight; $K_2O$ content: 13 % by weight) | 2.2 parts |
| Potassium hydroxide | 1.5 parts |
| Potassium sulfite | 0.9 part |
| Water | 90 parts |

| Developer replenishing solution (A): | |
|---|---|
| β-Anilinoethanol | 0.3 part |
| Propylene glycol | 0.6 part |
| 2-Hydroxy-3-naphthoic acid | 0.6 part |
| p-tert-Butyl benzoic acid | 1.5 parts |
| Emulgen 147 | 0.55 part |
| Potassium silicate | 6.0 parts |
| Potassium hydroxide | 3.1 parts |
| Potassium sulfite | 1.8 parts |
| Water | 82 parts |

Next, a JIS-1050 aluminum plate of 0.24 mm in thickness was immersed in an aqueous 2 % sodium hydroxide solution to carry out degreasing. Thereafter, the plate was surface-roughened by an electrochemical means in a diluted nitric acid solution, and then thoroughly cleaned, which was thereafter subjected to anodizing in a diluted sulfuric acid solution. An oxide coating of 2.5 g/$m^2$ was thus formed on the surface of the above aluminum plate. The aluminum plate thus treated was washed with water, and dried. Thereafter, a photosensitive solution having the following composition was coated thereon so as to give a dry weight of 2.5 g/$m^2$, and dried to give a positive working PS plate.

Composition of photosensitive coating solution:

Ester compound of naphthoquinone-(1,2)-diazido-(2)-5-sulfonic acid chloride with pyrogallol-acetone resin (the compound disclosed in Synthesis Example 2 in Japanese Unexamined Patent Publication No. 143345/1985) 2 parts

Copolycondensate resin of phenol, m- and p- mixed cresol and formaldehyde (when synthesized, phenol, m-cresol and p-cresol were charged in molar ratio of 20:48:32; weight average molecular weight Mw: 7,400; number average molecular weight Mn: 1,400) 6.5 parts

Ester compound of novolak resin synthesized from p-tert-octylphenol and formaldehyde, with naphthoquinone-(1,2)-diazido-(2)-5-sulfonic acid chloride (rate of condensation: 50 mol %; Mw: 1,700) 0.1 part

Victoria Pure Blue BOH 0.08 part
(available from Hodogaya Chemical Co., Ltd.)

Ethyl cellosolve 80 parts

Methyl cellosolve 20 parts

The positive working PS plate thus obtained was made ready for use in a large number, brought into close contact with a transparent positive film and a sensitivity-measuring step tablet (No. 2, available from Eastman Kodak Co.; a gray scale with 21 stages having each density difference of 0.15), and then exposed to light for 60 seconds with a distance of 70 cm under conditions of 8.0 $mW/cm^2$, using a 2 kW metal halide lamp (Idolfin 2000; manufactured by Iwasaki Electric Co., Ltd.) as a light source.

Next, a JIS-1050 aluminum plate of 0.24 mm in thickness was immersed in an aqueous 20 % sodium phosphate solution to carry out degreasing. Thereafter, the plate was surface-roughened by an electrochemical means in a diluted hydrochloric acid solution, and then thoroughly cleaned, which was thereafter subjected to anodizing in a diluted sulfuric acid solution. An oxide coating of 1.5 $g/m^2$ was thus formed on the surface of the above aluminum plate. The aluminum plate thus treated was further immersed in an aqueous sodium metasilicate solution to carry out sealing of the anodic oxide coating, then washed with water, and dried. Thereafter, a photosensitive solution having the following composition was coated thereon so as to give a dry weight of 2.0 $g/m^2$, and dried to give a negative working PS plate.

| Composition of photosensitive solution: | |
|---|---|
| Hexafluorophosphate of condensate of p-diazidodiphenylamine with paraformaldehyde | 1 part |
| N-(4-hydroxylphenyl)methacrylamide copolymer (the compound disclosed in Example 1 in Japanese Patent Publication No. 43890/1982) | 10 parts |
| Victoria Pure Blue BOH (a dye, available from Hodogaya Chemical Co., Ltd.) | 0.2 part |
| Ethylene glycol monomethyl ether | 100 parts |

The negative working PS plate thus obtained was made ready for use in a large number, brought into close contact with a transparent positive film and a sensitivity-measuring step tablet (No. 2, available from Eastman Kodak Co.; a gray scale with 21 stages having each density difference of 0.15), and then exposed to light for 30 seconds with a distance of 70 cm under conditions of 8.0 mW/cm$^2$, using a 2 kW metal halide lamp (Idolfin 2000; manufactured by Iwasaki Electric Co., Ltd.) as a light source.

Using the automatic processor set to operate, 50 positive PS plates and 50 negative PS plates were processed at random at 27°C in 20 seconds. During the processing, the developer replenishing solution was continually added in an amount of 50 ml for each processing of 1 m$^2$ of PS plates. Although the processing of the negative PS plates and the positive PS plates was carried out on 100 plates in total, no difference in quality was seen at all between the initial 1st plate and the last 100th plate.

In Fig. 1, the numeral 1 denotes a developing section, where developing is carried out; 2, a washing section; 3, a rinsing gum section, where processing is carried out using a rinse or a desensitizing solution; 4, a developer solution tank; 5 to 7, each a processing solution feed nozzle; 8, a developer replenishing solution tank; 9 to 12, pumps; and the letter symbol S, a PS plate or a guide path therefor.

Example 2

Example 1 was repeated to carry out an experiment, except that 10 positive PS plates and 90 negative PS plates were used and the developer replenishing solution was added in an amount of 45 ml for each processing of 1 m$^2$ of PS plates. As a result, no difference in quality was seen at all between the initial 1st plate and the last 100th plate.

Experiment 1

Example 1 was repeated, except that 90 positive PS plates and 10 negative PS plates were used and the developer replenishing solution was added in an amount of 55 ml for each processing of 1 m$^2$ of PS plates. As a result, a difference in quality was seen between the initial 1st plate and the last 100th plate.

Example 3

Example 1 was repeated, except that 70 positive PS plates and 30 negative PS plates were used and the developer replenishing solution was added in an amount of 55 ml for each processing of 1 m$^2$ of PS plates. As a result, no difference in quality was seen at all between the initial 1st plate and the last 100th plate.

Experiment 2

Example 1 was repeated, except that 30 positive PS plates and 70 negative PS plates were used and the developer replenishing solution was added in an amount of 50 ml for each processing of 1 m$^2$ of PS plates. As a result, a difference in quality was seen between the initial 1st plate and the last 100th plate.

The relationship between the processing number of the negative PS plates and the positive PS plates,

the amount of replenishment and the development quality in Examples 1 to 3 and Experiments 1 and 2 are shown in Fig. 2 (a graph). In Fig. 2, the numerals 1, 2 and 4 correspond to Examples 1, 2 and 3, respectively; and 3 and 5, Experiments 1 and 2, respectively. The graph shows that the development quality can be kept stable when the amount of replenishment is changed at a given rate, depending on the amount of processing of the negative PS plates and the positive PS plates.

| Comparative Example 1 | |
|---|---|
| Developer replenishing solution (B): | |
| β-Anilinoethanol | 0.3 part |
| Propylene glycol | 0.3 part |
| 2-Hydroxy-3-naphthoic acid | 0.6 part |
| p-tert-Butyl benzoic acid | 1.2 parts |
| Emulgen 147 | 0.03 part |
| Aqueous potassium silicate solution | 2.2 parts |
| Potassium hydroxide | 2.0 parts |
| Potassium sulfite | 0.9 parts |
| Water | 90 parts |

Using the above developer replenishing solution (B) and also using the same developer solution, automatic processor, positive PS plates and negative PS plates as in Example 1, processing was carried out in the same manner as in Example 1. In Example 1, a stable development quality was obtained when the replenishing solution (A) was added in an amount of 50 ml for each processing of 1 $m^2$ of PS plates. When, however, the replenishing solution (B) was used, it was impossible to find the amount of replenishment that can achieve a stable development quality.

Example 4

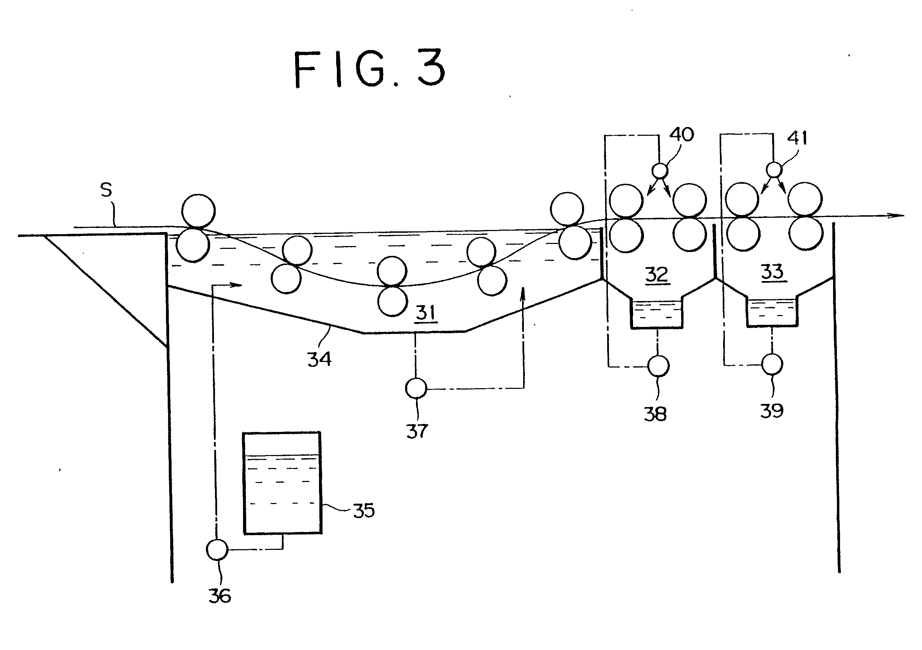

Entirely the same experiment as in Example 1 was carried out, except that an automatic processor as shown in Fig. 3 was used. As a result, it was possible to stably keep the development quality.

In Fig. 3, the numeral 31 denotes a developing section, where developing is carried out; 32, a washing section; 33, a rinsing gum section, where processing is carried out using a rinse or a desensitizing solution; 34, a developer solution tank; 35, a developer replenishing solution tank; 36 to 39, pumps; 40 and 41, shower nozzles; and the letter symbol S, a PS plate or a guide path therefor.

Example 5

Into the developer solution tank 34 of the automatic processer shown in Fig. 3, 24 liters of the developer solution used in Example I was charged, while into the developer replenishing solution tank 35, the following developer replenishing solution was charged.

| Developer replenishing solution C | |
|---|---|
| β-anilinoethanol | 0.42 part |
| Propylene glycol | 0.42 part |
| 2-Hydroxy-3-naphthoic acid | 0.82 part |
| p-tert-Butyl benzoic acid | 1.68 parts |
| Emulgen 147 | 0.07 part |
| Aqueous potassium silicate solution | 3.08 parts |
| Potassium hydroxide | 2.80 parts |
| Potassium sulfite | 1.26 parts |
| Water | 86.50 parts |

Using the automatic processor set to operate, 50 positive working PS plates and 50 negative working PS plates used in Example 1 were processed at random at 30° C in 15 seconds, During the processing, the developer replenishing solution was continually added in an amount of 60 ml for each processing of 1 $m^2$ of PS plates. Although the processing of the negative working PS plates and the positive working PS plates was carried out on 100 plates in total, no difference in quality was seen at all between the initial 1st plate and the last 100th plate.

As having been described above, in the method of processing a negative working PS plate and a positive working PS plate with a common developer solution repeatedly used under supply of a replenishing solution, this invention makes it possible to stably maintain development quality and also can simplify the manner for replenishing a developer solution and the apparatus used therefor.

## Claims

1. A method of processing a presensitized lithographic printing plate by the use of an automatic processor, comprising processing a negative working presensitized lithographic printing plate containing a diazo compound and a positive working presensitized lithographic printing plate containing an o-quinonediazide compound, with a developer solution capable of processing the negative working presensitized lithographic printing plate and the positive working presensitized lithographic printing plate in common, repeatedly used under supply of a developer replenishing solution, wherein;
said developer solution and said developer replenishing solution each contain an alkali silicate, a surface active agent, an organic solvent and a reducing agent;
said developer replenishing solution is a single liquid;
said developer replenishing solution contains said surface active agent in an amount ranging from 0.05 to 15 % by weight; and
said developer replenishing solution is different from said developer solution in the concentration of at least one of the alkali silicate, the surface active agent, the organic solvent and the reducing agent.

2. The method of processing a presensitized lithographic printing plate according to Claim 1, wherein the alkali silicate is at least one selected from the group consisting of potassium silicate, sodium silicate, sodium metasilicate, potassium metasilicate and ammonium silicate.

3. The method of processing a presensitized lithographic printing plate according to Claim 1, wherein the alkali silicate is contained in the developer solution in an amount ranging from 0.3 to 10 % by weight, and in the developer replenishing solution in an amount ranging from 0.5 to 10 % by weight.

4. The method of processing a presensitized lithographic printing plate according to Claim 1, wherein the surface active agent is at least one selected from the group consisting of an anionic surface active agent, a nonionic surface active agent and a cationic surface active agent.

5. The method of processing a presensitized lithographic printing plate according to Claim 4, wherein the anionic surface active agent is selected from the group consisting of higher alcohol ($C_8$ to $C_{22}$) sulfuric acid ester salts, aliphatic alcohol phosphoric acid ester salts, alkylaryl sulfonic acid salts, sulfonates of alkylamides and sulfonates of dibasic fatty acid esters.

6. The method of processing a presensitized lithographic printing plate according to Claim 4, wherein the nonionic surface active agent is a nonionic surface active agent of polyethylene glycol type having three or more ethylene oxy groups and an HLB value of not less than 5.

7. The method of processing a presensitized lithographic printing plate according to Claim 6, wherein the HLB value ranges from 8 to 20.

8. The method of processing a presensitized lithographic printing plate according to Claim 6, wherein the nonionic surface active agent has both an ethylene oxy group and a propylene oxy group and has an HLB value of not less than 8.

9. The method of processing a presensitized lithographic printing plate according to Claim 4, wherein the nonionic surface active agent is at least one selected from the group consisting of polyethylene glycol, polyoxyethylene lauryl ether, polyoxyethylene nonyl ether, polyoxyethylene cetyl ether, polyoxyethylene stearyl ether, polyoxyethylene oleyl ether, polyoxyethylene behenyl ether, polyoxyethylene polyoxypropylene cetyl ether, polyoxyethylene polyoxypropylene behenyl ether, polyoxyethylene nonyl phenyl ether, polyoxyethylene octyl phenyl ether, polyoxyethylene stearylamine, polyoxyethylene oleylamine, polyoxyethylene stearic acid amide, polyoxyethylene oleic acid amide, polyoxyethylene castor oil, polyoxyethylene abietyl ether, polyoxyethylene lanolin ether, polyoxyethylene monolaurate, polyoxyethylene monostearate, polyoxyethylene glyceryl monooleate, polyoxyethylene glyceryl monostearate, polyoxyethylene propylene glycol monostearate, an oxyethylene oxypropylene block polymer, a distyrated-phenol

polyethylene oxide adduct, a tribenzylphenol polyethylene oxide adduct, an octylphenol polyoxyethylene polyoxypropylene adduct, glycerol monostearate, sorbitan monolaurate and polyoxyethylene sorbitan monolaurate.

10. The method of processing a presensitized lithographic printing plate according to Claim 4, wherein the nonionic surface active agent has a weight average molecular weight ranging from 300 to 10,000.

11. The method of processing a presensitized lithographic printing plate according to Claim 4, wherein the nonionic surface active agent has a weight average molecular weight ranging from 500 to 5,000.

12. The method of processing a presensitized lithographic printing plate according to Claim 4, wherein the nonionic surface active agent is at least one selected from the group consisting of the compounds represented by the following Formulas (1) to (8).

(1) $R\text{-}O\text{-}(CH_2CH_2O)_nH$

(2)

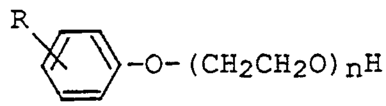

(3)

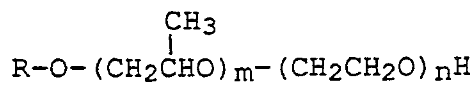

(4)

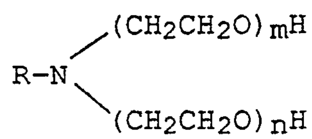

(5)

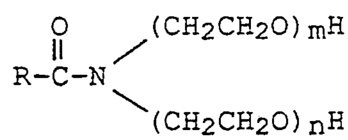

(6) $HO(C_2H_4O)_a-(C_3H_6O)_b-(C_2H_4O)_cH$

(7)

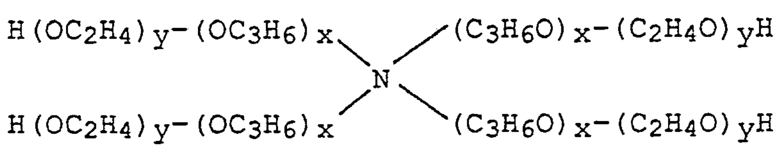

(8) $HO-(CH_2CH_2O)_nH$

in Formulas (1) to (8), R represents a hydrogen atom or a monovalent organic group, and the letter symbols a, b, c, m, n, x and y each represent an integer of 1 to 40.

13. The method of processing a presensitized lithographic printing plate according to Claim 12, wherein the monovalent organic group is at least one selected from the group consisting of a straight-chain or branched alkyl group having 1 to 30 carbon atoms which may have a substituent, an alkylcarbonyl group in which the alkyl moiety is as the above alkyl group, and a phenyl group which may have a substituent.

14. The method of processing a presensitized lithographic printing plate according to Claim 4, wherein the cationic surface active agent is at least one selected from the group consisting of a polyoxyethylene alkylamine, a N-alkylpropyleneamine, a N-alkylpolyethylene polyamine, a N-alkylpolyethylene polyamine dimethyl sulfate, an alkylbiguanide, a long-chain amine oxide, an alkylimidazoline, a 1-hydroxyethyl-2-alkylimidazoline, a 1-acetylaminoethyl-2-alkylimidazoline, a 2-alkyl-4-methyl-4-hydroxymethyloxazoline, a

long-chain primary amine salt, an alkyltrimethylammonium salt, a dialkyldimethylethylammonium salt, an alkyldimethylammonium salt, an alkyldimethylbenzylammonium salt, an alkylpyridinium salt, an alkylquinolinium salt, an alkyl isoquinolinium salt, an alkylpyridinium sulfate, a stearamidomethylpyridinium salt, an acylaminoethyl diethylamine salt, an acylaminoethyl methyldiethylammonium salt, an alkylamidopropyl dimethylbenzylammonium salt, a fatty acid polyethylene polyamide, an acylaminoethyl-pyridinium salt, an acylcolaminoformylmethylpyridinium salt, a stearoxymethylpyridinium salt, a fatty acid triethanolamine, a fatty acid triethanolamine formate, a trioxyethylene fatty acid triethanolamine, a fatty acid dibutylaminoethanol, a cetyloxymethylpyridinium salt, and a p-isooctylphenoxyethoxyethyl dimethylbenzylammonium salt.

15. The method of processing a presensitized lithographic printing plate according to Claim 1, wherein the surface active agent is contained in the developer solution in an amount ranging from 0.01 to 10 % by weight, and in the developer replenishing solution 0.05 to 15 % by weight.

16. The method of processing a presensitized lithographic printing plate according to Claim 1, wherein the organic solvent is selected from the group consisting of ethyl acetate, propyl acetate, butyl acetate, benzyl acetate, ethylene glycol monobutylacetate, butyl lactate, butyl levulinate, ethyl butyl ketone, methyl isobutyl ketone, cyclohexanone, ethylene glycol monobutyl ether, ethylene glycol benzyl ether, ethylene glycol monophenyl ether, propylene glycol, propylene glycol monomethyl ether, benzyl alcohol, methylphenylcarbinol, n-amyl alcohol, methylaminoalcohol, monoethanolamine, diethanolamine, triethanolamine, $\beta$-anilinoethanol, xylene, methylene dichloride, ethylene dichloride and monochlorobenzene.

17. The method of processing a presensitized lithographic printing plate according to Claim 1, wherein the organic solvent is contained in the developer solution in an amount ranging from 0.05 to 10 % by weight, and in the developer replenishing solution in an amount ranging from 0.05 to 10 % by weight.

18. The method of processing a presensitized lithographic printing plate according to Claim 1, wherein the reducing agent is at least one selected from the group consisting of hydroquinone, methol, methoxyquinone, phenylenediamine, phenylhydrazine, sodium sulfite, potassium sulfite, ammonium sulfite, sodium hydrogensulfite, potassium hydrogensulfite, sodium phosphite, potassium phosphite, sodium hydrogenphosphite, potassium hydrogenphosphite, sodium dihydrogenphosphite, dipotassium hydrogenphosphite, hydrazine, sodium thiosulfate and sodium dithiosulfite.

19. The method of processing a presensitized lithographic printing plate according to Claim 1, wherein the reducing agent is contained in the developer solution in an amount ranging from 0.1 to 20 % by weight, and in the developer replenishing solution in an amount ranging from 0.5 to 30 % by weight.

20. The method of processing a presensitized lithographic printing plate according to Claim 1, wherein the concentra tion of the surface active agent is made higher in the developer replenishing solution than in the developer solution.

21 The method of processing a presensitized lithographic printing plate according to Claim 1, wherein the concentration of the reducing agent is made higher in the developer replenishing solution than in the developer solution.

22. The method of processing a presensitized lithographic printing plate according to Claim 1, wherein the developer solution has a pH ranging from 12.5 to 13.5, the developer replenishing solution has a pH ranging from 12.8 to 13.8, and the pH of the developer replenishing solution is higher than the pH of the developer solution.

FIG. 1

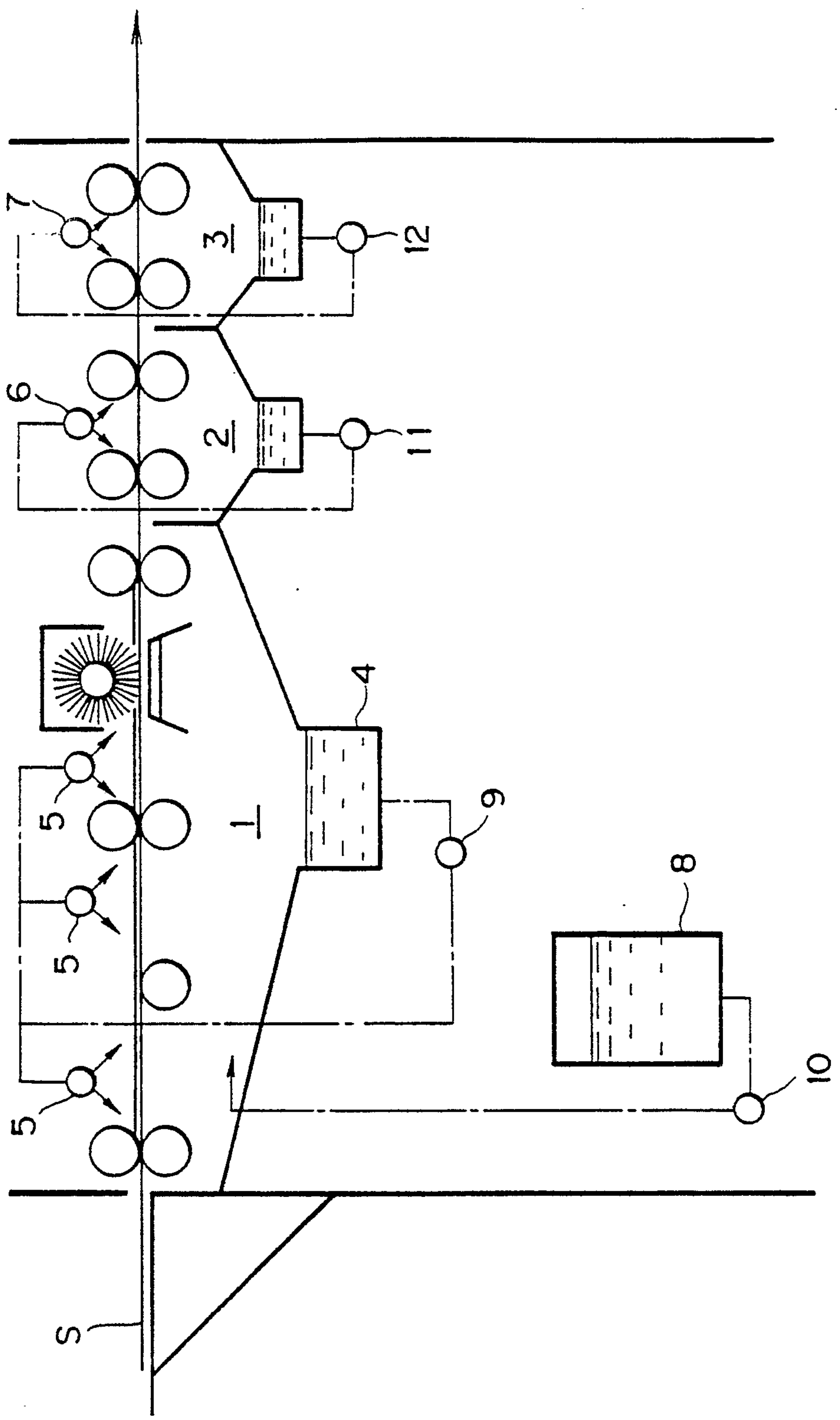

FIG. 2

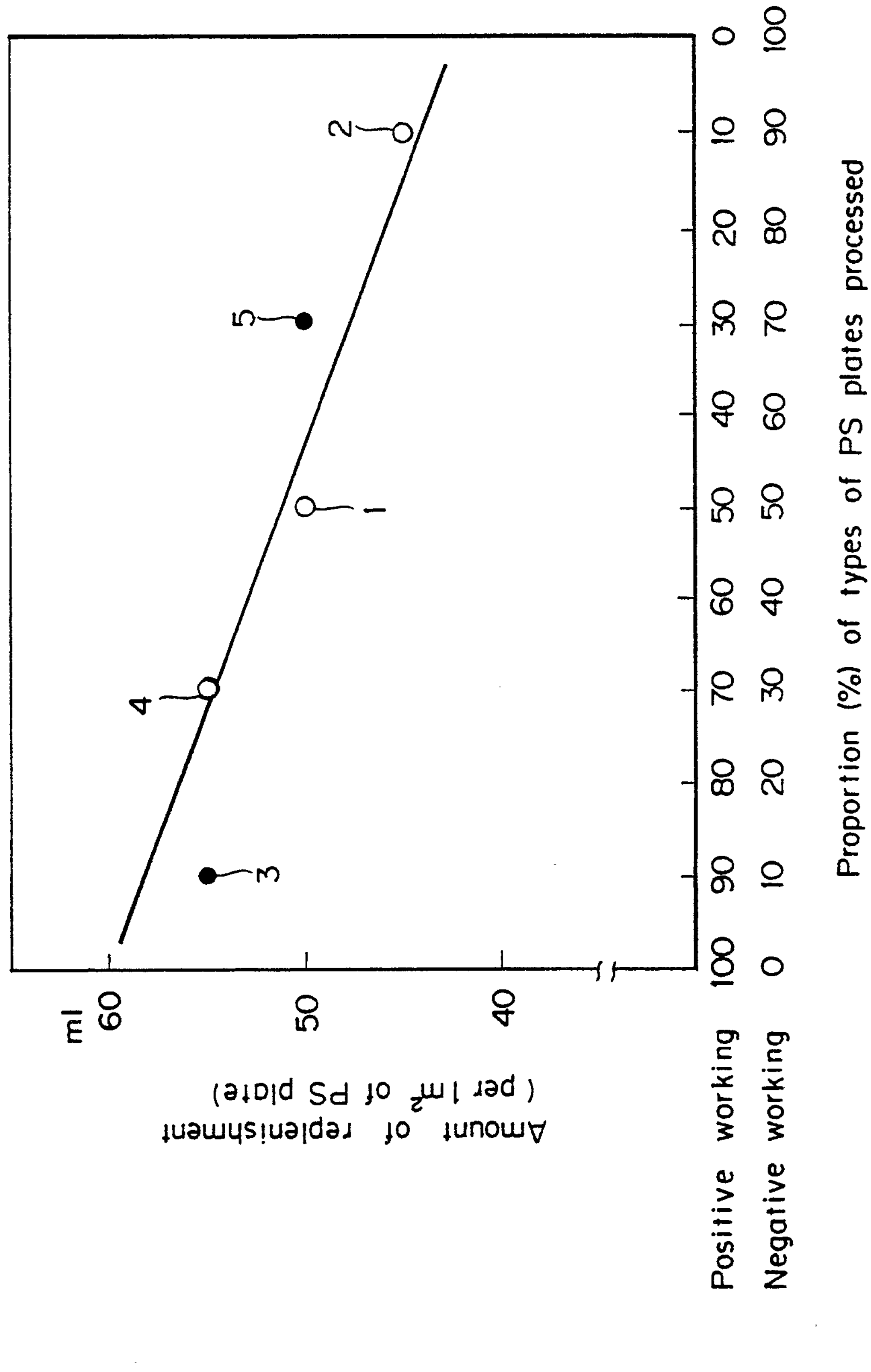
ml
60
50
40
Amount of replenishment
( per 1m² of PS plate)
1
2
3
4
5
Positive working 100 90 80 70 60 50 40 30 20 10 0
Negative working 0 10 20 30 40 50 60 70 80 90 100
Proportion (%) of types of PS plates processed

FIG. 3